# EUROPÄISCHE PATENTSCHRIFT

(11) **EP 0 444 253 B1**
(45) Veröffentlichungstag und Bekanntmachung des Hinweises auf die Patenterteilung: **14.09.1994**
(21) Anmeldenummer: 90122828.8
(22) Anmeldetag: 29.11.1990
(51) Int. Cl.: C23C 14/56, C23C 14/34

(54) **Vorrichtung zum Aufbringen dünner Schichten auf ein Substrat**
Apparatus for the deposition of thin layers on a substrate
Appareillage pour la déposition des couches minces sur un substrat

(30) Priorität: 01.03.1990 DE 4006411
(43) Veröffentlichungstag der Anmeldung: 04.09.1991
(73) Patentinhaber: LEYBOLD AKTIENGESELLSCHAFT, D-63450 Hanau (DE)
(72) Erfinder: Lueft, Gerold, W-6460 Gelnhausen 2 (DE)

(56) Entgegenhaltungen:
- EP-A- 0 205 028
- WO-A-85/02418
- WO-A-89/07664
- GB-A- 2 219 311
- US-A- 4 401 689

## Beschreibung

Die Erfindung betrifft eine Vorrichtung zum Aufbringen dünner Schichten auf ein Substrat mittels des Kathodenzerstäubungsverfahrens in einer Vakuumkammer, durch die das zu beschichtende Substrat hindurchbewegbar ist und mit einer zwischen einer zu zerstäubenden Kathode und einer Anode angeordneten Blende, wobei die Substratebene unterhalb der Anode verläuft und wobei von der Wand der Vakuumkammer gehaltene, mit Kanälen versehene Hohlprofile - parallel zur Kathodenebene und im Bereich zwischen der Kathode und der Anode - vorgesehen sind, die von einem Temperiermedium und von einem Prozeßgas durchströmt sind, wobei die Kanäle für das Prozeßgas Öffnungen aufweisen, die quer zur Längsachse dieses Kanals verlaufen und den Austritt von Prozeßgas in die Vakuumkammer ermöglichen.

Es ist eine Vorrichtung zum Aufbringen dünner Schichten auf ein Substrat mittels des Kathodenzerstäubungsverfahrens bekannt (EP 0 205 028). Hierbei ist zwischen der zu zerstäubenden Kathode und der Anode eine mechanische Blende vorgesehen, welche den Raum zwischen der Kathode und dem zu beschichtenden Substrat unterteilt. Diese Vorrichtung ist mit mehreren separaten Kühlrohren und Gasleitungsrohren für die Versorgung mit Temperiermedium und Prozeßgas versehen.

Weiterhin kennt man im Stand der Technik eine Gas-Einlaß und Entlade-Einrichtung für die Behandlung von Werkstücken mittels eines Plasma-CVD-Verfahrens (GB 2 219 311 A), insbesondere für das Einlassen und das Entfernen von Prozeß-Gas in, bzw. aus einer Reaktions-Kammer. Dafür sind im wesentlichen ein plattenförmiger Grundkörper und mehrere Hohl-Nadeln vorgesehen, wobei das Prozeß-Gas durch diese Nadeln fein verteilt in die Reaktionszone eingelassen und umgehend nach dem Prozeß durch die Nadeln umgebende Vertiefungen wieder entfernt wird. Dadurch wird eine homogene Schichtverteilung auf den Substraten, sowie eine Verbesserung der Sauberkeit in der Prozeß-Kammer erreicht.

Diese bekannten Vorrichtungen haben den Nachteil, daß die Zu- und Rückführung des Temperiermediums sowie die Versorgung mit Prozeßgas jeweils über separate, mehrstückige Rohrleitungen erfolgt und somit sehr anfällig für Betriebsstörungen und aufwendig in der Herstellung und Wartung ist. Die Rohrleitungen weisen nämlich Biegungen, Wicklungen, Schraubverbindungen und Lötstellen auf, die sich unter Betriebsbedingungen der Vorrichtung im Vakuum befinden, was durch zusätzlichen Einfluß von prozeßbedingter Wärme zu Haarrissen und Undichtigkeiten in den Rohrleitungen führt. Diese Undichtigkeiten (Lecks) beeinträchtigen zunächst die Schichtqualität, beispielsweise die Haftfähigkeit, der auf das Substrat aufzubringenden Schicht beim Zerstäubungsprozeß (Sputtern) oder beim CVD-Verfahren und führen anschließend und zwangsläufig zum Total-Ausfall der Gesamtanlage, der immer mit erheblichem Aufwand und immensen Kosten verbunden ist.

Der Erfindung liegt deshalb die Aufgabe zugrunde, die Vorrichtung in der Weise zu verbessern, daß die Betriebssicherheit spürbar erhöht und damit die Ausfallzeiten reduziert, die Herstellung und Wartung deutlich vereinfacht und damit eine wesentliche Reduzierung der Herstell- und Betriebskosten erreicht werden.

Diese Aufgabe wird erfindungsgemäß daduch gelöst, daß sowohl das Temperiermedium als auch das Prozeßgas in Kanälen geführt werden, die von einem einstückig und als Hohlprofil ausgeformten Bauteil gebildet sind, wobei Öffnungen für den Austritt des Gases quer zur Längsachse der Kanäle verlaufen.

Die Vorrichtung weist ein Hohlprofil auf, das durch eine rechteckige Querschnittsfläche mit abgerundeten Ecken gekennzeichnet ist. Dieses Profil ist mit Vorteil einfach in der Herstellung, hat eindeutige und gut zugängliche Kontaktstellen und ermöglicht den Anschluß von Temperiermedium und Prozeßgas außerhalb der Vakuumkammer.

Weitere Ausführungsmöglichkeiten und Merkmale sind in den Unteransprüchen näher beschrieben und gekennzeichnet.

Die Erfindung läßt die verschiedensten Ausführungsmöglichkeiten zu; eine davon ist in den anhängenden Zeichnungen näher dargestellt, und zwar zeigen:
- Figur 1: einen Teil der Vorrichtung zum Aufbringen dünner Schichten auf ein Substrat mittels des Kathodenzerstäubungsverfahrens im Schnitt, bestehend im wesentlichen aus der Anode, dem Hohlprofil, der Blende und den Klemmelementen, wobei ein Teil der Vakuumkammer, das Substrat und die Kathode strichpunktiert dargestellt sind,
- Figur 2: das linke Endstück des Hohlprofils gemäß Figur 1 mit der Flanschbefestigung an der Vakuumkammer in der Seitenansicht und vergrößert, wobei die Wand der Vakuumkammer strichpunktiert dargestellt ist,
- Figur 3: das rechte, freie Endstück des Hohlprofils in einer gegenüber Figur 2 um 90° gedrehten Schnittdarstellung mit den Kanälen für das Temperiermedium,
- Figur 4: das Hohlprofil mit Befestigungsflansch gemäß Figur 2 in der Seitenansicht und in verkleinerter Darstellung und
- Figur 5: einen Kanal für Prozeßgas mit zwei Reduzierstücken und einem Gasverteilerrohr im Schnitt und vergrößert.

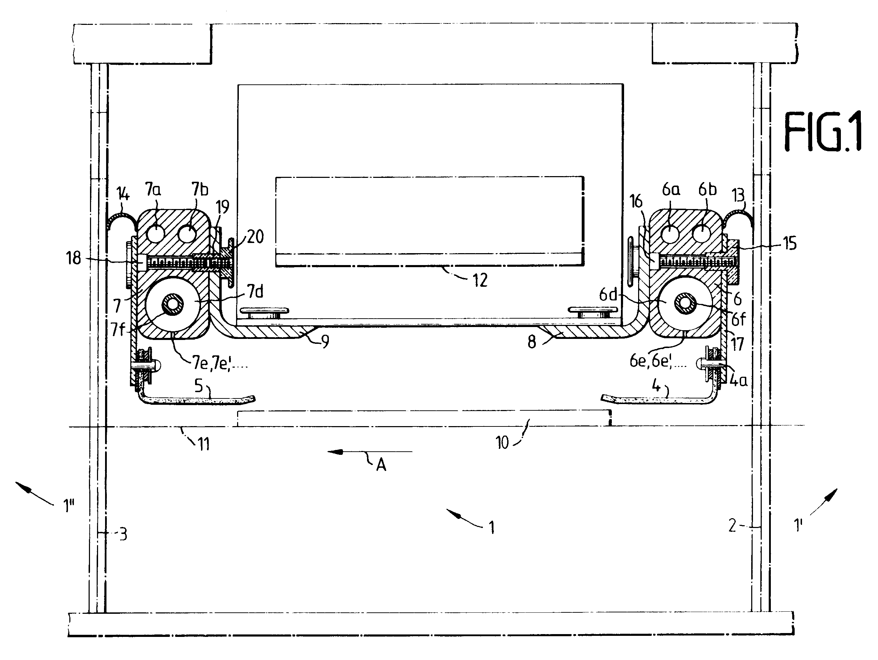

Wie Figur 1 zeigt, schließen sich seitlich der rechteckigen Vakuumkammer 1 noch weitere Vakuumkammern 1', 1'' an, die über die Schleusen 2, 3 in einer Linie miteinander verbunden sind.

In der Vakuumkammer 1 sind die Anoden 4, 5 parallel zueinander und quer zur Erstreckungsrichtung der Kammern 1, 1' und 1'' so angeordnet, daß sich die rechteckigen Hohlprofile 6, 7 sowie die Blenden 8, 9 zur Kammermitte hin anschließen, wobei die Kanäle für Temperiermediumzulauf 6a, 7a und -rücklauf 6b, 7b oberhalb der Kanäle für Prozeßgas 6d, 7d plaziert sind, in denen wiederum die Gasverteilerrohre 6f, 7f zentrisch befestigt sind. Weiterhin sind die Kanäle für Prozeßgas 6d, 7d, ... auf der Unterseite mit sich in bestimmten Abständen wiederholenden Öffnungen 6e, 6e', ...; 7e, 7e', ... für den Austritt des Prozeßgases aus den Kanälen 6d, 7d in die Vakuumkammer 1 versehen. Das Substrat 10 ist unterhalb der Anoden 4, 5 auf der sich horizontal erstreckenden Substratebene 11 und in Bewegungsrichtung A durch die Vakuumkammer hindurch bewegbar.

Die Kathode 12 befindet sich oberhalb und zwischen den Blenden 8, 9 und erstreckt sich parallel zu den Hohlprofilen 6, 7 und somit quer zur Bewegungsrichtung A des Substrates.

Die beiden U-förmigen Dicht-/Leitbleche 13, 14 sind so angeordnet, daß sie die zwischen den Hohlprofilen 6, 7 und den Kammerwänden der Vakuumkammer 1 verbleibenden Spalte verschließen.

Die Isolierbuchse 15 fixiert mit der Schraube 16 die Isolierleiste 17, an der über die Klemmvorrichtung 4a die Anode 4 befestigt ist, mit dem Hohlprofil 6. Die Schraube 18 verbindet über die Arretierbuchse 19 und die Klemmschraube 20 das Hohlprofil 7 mit der Blende 9.

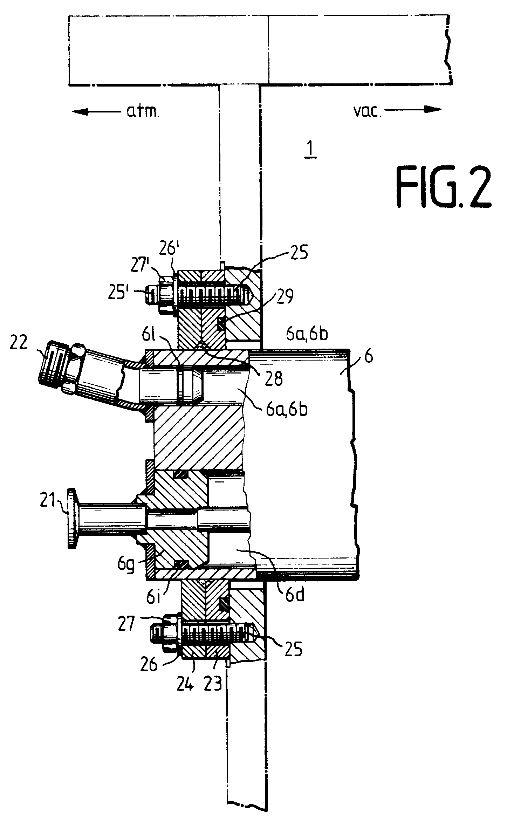

Der Flansch für Prozeßgas 21 und der Schraubanschluß für Temperiermedium 22 sind stirnseitig an dem aus der Vakuumkammer 1 herausragenden Ende des Hohlprofils 6 angebracht, wobei der Flansch für Prozeßgas 21 mit dem Reduzierstück 6g verschweißt ist und mit dem Dichtring 6i den Kanal für Prozeßgas 6d abdichtet und der Schraubanschluß für Temperiermedium 22 mit dem Dichtring 6l den Kanal für Temperiermedium 6a, 6b abdichtet (Figur 2).

Durch den Zwischenflansch 23, den Endflansch 24 sowie die Gewindebolzen 25, 25', ..., die Scheiben 26, 26', ... und die Muttern 27, 27', ... wird das Hohlprofil 6 in seiner Lage in der Vakuumkammer 1 fixiert und durch die Vakuumdichtringe 28, 29 gegen Atmosphärendruck gedichtet (Figur 2).

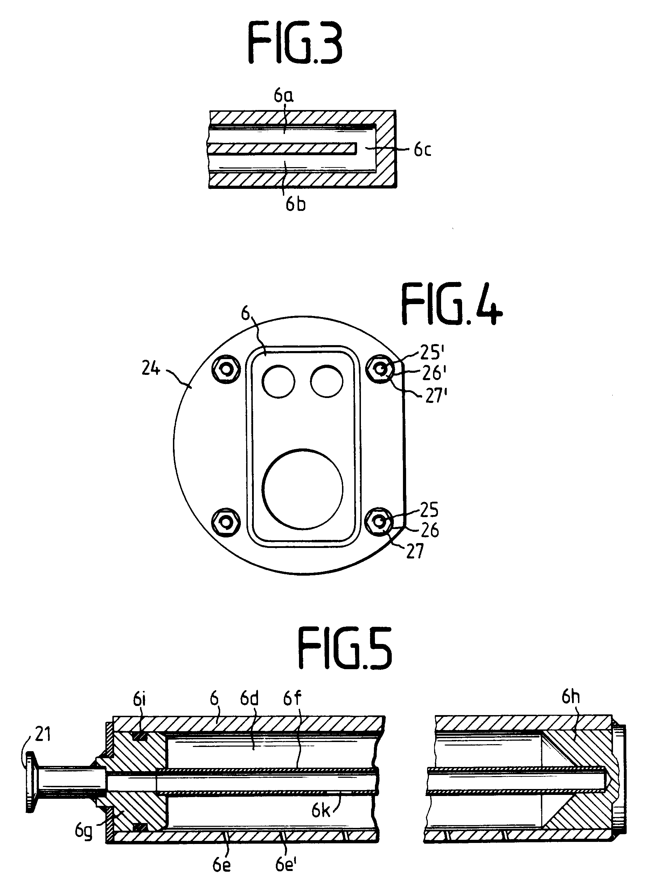

Der Kanal für Temperiermediumzulauf 6a ist über den Verbindungskanal 6c mit dem Rücklaufkanal 6b verbunden (Figur 3).

Der Endflansch 24 wird über die auf einem Teilkreis symmetrisch angeordneten Gewindebolzen 25, 25', ..., Scheiben 26, 26', ... und Muttern 27, 27', ... fixiert und zentriert somit das rechteckige Hohlprofil 6 in seiner Position an der Wand der in Figur 2 gezeigten Vakuumkammer 1 (Figur 4).

In dem Kanal für Prozeßgas 6d ist das Gasverteilerrohr 6f mit einer in der Mitte der axialen Erstrekkungslänge vorgesehenen Öffnung 6k zur gleichmäßigen Verteilung des Prozeßgases im Kanal 6d so angeordnet, daß es durch die Reduzierstücke 6g, 6h sowohl zentriert als auch axial fixiert ist und mit dem Dichtring 6i den Gaskanal zum Hohlprofil 6 hin abdichtet, wobei der Flansch für Prozeßgas 21 mit dem Reduzierstück 6g verschweißt ist. Der Kanal für Prozeßgas 6d ist auf der Unterseite mit sich in bestimmten Abständen wiederholenden Öffnungen 6e, 6e', ... für den Austritt des Prozeßgases aus dem Kanal 6d in die in Figur 1 bereits gezeigte Vakuumkammer 1 versehen (Figur 5).

### Auflistung der Einzelteile

- 1, 1', 1'': Vakuumkammer
- 2: Schleuse
- 3: Schleuse
- 4: Anode
- 4a: Klemmvorrichtung
- 5: Anode
- 6: Hohlprofil
- 6a: Kanal für Temperiermediumzulauf
- 6b: Kanal für Temperiermediumrücklauf
- 6c: Verbindungskanal für Temperiermedium
- 6d: Kanal für Prozeßgas
- 6e, 6e', ...: Öffnung
- 6f: Gasverteilerrohr
- 6g: Reduzierstück
- 6h: Reduzierstück
- 6i: Dichtring
- 6k: Öffnung
- 6l: Dichtring
- 7: Hohlprofil
- 7a: Kanal für Temperiermediumzulauf
- 7b: Kanal für Temperiermediumrücklauf
- 7c: Verbindungskanal für Temperiermedium
- 7d: Kanal für Prozeßgas
- 7e, 7e', ...: Öffnung
- 7f: Gasverteilerrohr
- 7k: Öffnung
- 8: Blende
- 9: Blende
- 10: Substrat
- 11: Substratebene
- 12: Kathode
- 13: Dicht-/Leitblech
- 14: Dicht-/Leitblech
- 15: Isolierbuchse
- 16: Schraube
- 17: Isolierleiste
- 18: Schraube
- 19: Arretierbuchse
- 20: Klemmschraube
- 21: Flansch für Prozeßgas
- 22: Schraubanschluß für Temperiermedium
- 23: Zwischenflansch
- 24: Endflansch
- 25, 25', ...: Gewindebolzen
- 26, 26', ...: Scheiben
- 27, 27', ...: Muttern
- 28: Vakuumdichtring
- 29: Vakuumdichtring
- A: Bewegungsrichtung des Substrats

## Patentansprüche

1. Vorrichtung zum Aufbringen dünner Schichten auf ein Substrat (10) mittels des Kathodenzerstäubungsverfahrens in einer Vakuumkammer (1), durch die das zu beschichtende Substrat (10) hindurchbewegbar ist und mit einer zwischen einer zu zerstäubenden Kathode (12) und einer Anode (4, 5) angeordneten Blende (8, 9), wobei die Substratebene (11) unterhalb der Anode (4, 5) verläuft und wobei von der Wand der Vakuumkammer (1) gehaltene Medienführungsmittel (6, 7) parallel zur Kathodenebene und im Bereich zwischen der Kathode (12) und der Anode (4, 5) vorgesehen sind, die von einem Temperiermedium und von einem Prozeßgas durchströmt sind, wobei die Medienführungsmittel (6, 7) Öffnungen (6e, 6e', ...; 7e, 7e', ...) für den Austritt von Prozeßgas in die Vakuumkammer (1) aufweisen, **dadurch gekennzeichnet,** daß sowohl das Temperiermedium als auch das Prozeßgas in Kanälen (6a, 6b, 6d; 7a, 7b, 7d) geführt sind, die von einem einstückig, als Hohlprofil (6, 7) ausgeformten Bauteil gebildet sind, wobei die Öffnungen (6e, 6e', ...; 7e, 7e', ...) für den Austritt des Gases quer zur Längsachse der Kanäle verlaufen.

2. Vorrichtung nach Anspruch 1, **dadurch gekennzeichnet,** daß das Hohlprofil (6, 7) eine rechteckige Querschnittsfläche aufweist, deren Ecken abgerundet sind.

3. Vorrichtung nach Anspruch 1, **gekennzeichnet durch** ein Hohlprofil (6, 7), dessen Querschnittsfläche als Dreieck oder als Vieleck ausgeformt ist, wobei eine oder mehrere Ecken abgerundet oder als Kreisbögen ausgebildet sind.

4. Vorrichtung nach Anspruch 1, 2 oder 3, **dadurch gekennzeichnet,** daß das Hohlprofil (6, 7) mit mehreren achsparallelen Kanälen, vorzugsweise für Temperiermediumzulauf (6a, 7a), Temperiermediumrücklauf (6b, 7b) und Prozeßgas (6d, 7d), vergesehen ist.

5. Vorrichtung nach einem oder mehreren der vorhergehenden Ansprüche, **dadurch gekennzeichnet,** daß ein oder mehrere Kanäle (6a, 6b, 6d; 7a, 7b, 7d) eine rechteckige Querschnittsfläche aufweisen.

6. Vorrichtung nach einem oder mehreren der vorhergehenden Ansprüche**, dadurch gekennzeichnet,** daß die Kanäle für den Zu- und Rücklauf (6a, 7a; 6b, 7b) des Temperiermediums einen gleichgroßen Querschnitt aufweisen.

7. Vorrichtung nach einem oder mehreren der vorhergehenden Ansprüche, **dadurch gekennzeichnet,** daß der Kanal für das Prozeßgas (6d, 7d) eine größere Querschnittsfläche aufweist als der Kanal für den Zu- und Rücklauf (6a, 7a; 6b, 7b) des Temperiermediums.

8. Vorrichtung nach einem oder mehreren der vorhergehenden Ansprüche, **dadurch gekennzeichnet,** daß in dem Kanal für Prozeßgase (6d, 7d) ein Gasverteilerrohr (6f, 7f) angeordnet ist.

9. Vorrichtung nach Anspruch 8, **dadurch gekennzeichnet,** daß der Gasaustritt aus dem Gasverteilerrohr (6f, 7f) in den Kanal für Prozeßgas (6d, 7d) vorzugsweise durch eine als Bohrung ausgebildete Öffnung (6k, 7k) erfolgt

10. Vorrichtung nach Anspruch 9, **dadurch gekennzeichnet,** daß die Öffnung (6k, 7k) vorzugsweise in der Mitte der axialen Erstreckungslänge des Rohres vorgesehen und senkrecht nach unten angeordnet ist.

11. Vorrichtung nach einem oder mehreren der vorhergehenden Ansprüche, **dadurch gekennzeichnet,** daß der Gasaustritt aus dem Kanal für Prozeßgas (6d, 7d) in die Vakuumkammer (1) durch vorzugsweise als Bohrungen ausgebildete Öffnungen (6e, 6e', ...; 7e, 7e', ...) erfolgt.

12. Vorrichtung nach Anspruch 11, **dadurch gekennzeichnet,** daß die Gasverteilung durch die in bestimmten Abständen quer zur Längsachse des Kanals (6d, 7d) und senkrecht nach unten angeordneten Öffnungen (6e, 6e', ...; 7e, 7e', ...) erfolgt.

13. Vorrichtung nach Anspruch 12, **dadurch gekennzeichnet,** daß die durch die Öffnungen (6e, 6e', ...; 7e, 7e', ...) in der Vakuumkammer (1) erzeugte Gasströmung durch Dicht-/Leitbleche (13, 14) unterbrochen ist, die jeweils den Zwischenraum zwischen der Kammerinnenwand und dem Hohlprofil (6, 7) ausfüllen und vorzugsweise jeweils am Hohlprofil (6, 7) fest angeordnet sind.

14. Vorrichtung nach einem oder mehreren der vorhergehenden Ansprüche, **dadurch gekennzeichnet,** daß in die Kanäle (6a, 6b, 6d; 7a, 7b, 7d) rohrförmige Einsätze einbringbar sind, deren Querschnittsfläche der lichten Querschnittsfläche der Kanäle angepaßt sind und die den Druckverlust des im jeweiligen Kanal strömenden Mediums mindern.

15. Vorrichtung nach einem oder mehreren der vorhergehenden Ansprüche, **dadurch gekennzeichnet,** daß das einstückig ausgeführte Hohlprofil (6) durch eine Öffnung in der Wand der Vakuumkammer (1) nach außen zu hindurchgeführt ist, wobei die Querschnittsfläche der Öffnung derjenigen des Hohlprofils (6) angepaßt ist und wobei zwischen beiden Teilen eine Dichtung vorgesehen ist.

16. Vorrichtung nach einem oder mehreren der vorhergehenden Ansprüche, **dadurch gekennzeichnet,** daß das Hohlprofil (6) in unmittelbarem Bereich der Öffnung in der Kammerwand von einem Kragen oder Flansch (23, 24) umschlossen ist, der seinerseits dicht an der Kammeraußenwand anliegt und der über mindestens eine Dichtung (28, 29) den Spalt zwischen dem Hohlprofil (6), der Kammerwand und dem Flansch (23, 24) verschließt.

17. Vorrichtung nach Anspruch 16, **dadurch gekennzeichnet,** daß der Anschluß (21) für die das Prozeßgas führende Leitung sowie der Anschluß (22) für die das Temperiermedium führende Leitung an einer Stirnseite des Hohlprofils (6) und außerhalb der Vakuumkammer (1) angeordnet sind.

## Claims

1. Apparatus for applying thin coatings to a substrate (10) by means of the cathode sputtering process in a vacuum chamber (1), through which chamber the substrate (10) to be coated can be moved, and having a screen (8, 9) disposed between a cathode (12) to be sputtered and an anode (4, 5), wherein the substrate plane (11) extends below the anode (4, 5), and means (6, 7) for carrying the medium, which are held by the wall of the vacuum chamber (1), are provided parallel to the cathode plane and in the region between the cathode (12) and the anode (4, 5), through which means a tempering medium and a process gas pass, the medium-carrying means (6, 7) having apertures (6e, 6e', ...; 7e, 7e', ...) for discharging the process gas into the vacuum chamber (1), characterised in that both the tempering medium and the process gas are guided in channels (6a, 6b, 6d; 7a, 7b, 7d), which are formed by a one-piece component in the form of a hollow profile (6, 7), the apertures (6e, 6e', ...; 7e, 7e',...) for discharging the gas extending transverse to the longitudinal axis of the channels.

2. Apparatus according to claim 1, characterised in that the hollow profile (6, 7) has a rectangular cross-sectional area, whose corners are rounded.

3. Apparatus according to claim 1, characterised by a hollow profile (6, 7) whose cross-sectional area is triangular or polygonal, one or more corners being rounded or arc-shaped.

4. Apparatus according to claim 1, 2 or 3, characterised in that the hollow profile (6, 7) is provided with a plurality of axially parallel channels, preferably for tempering medium supply (6a, 7a), tempering medium discharge (6b, 7b), and process gas (6d, 7d).

5. Apparatus according to one or more of the preceding claims, characterised in that one or more channels (6a, 6b, 6d; 7a, 7b, 7d) have a rectangular cross-sectional area.

6. Apparatus according to one or more of the preceding claims, characterised in that the channels for supplying and discharging (6a, 7a; 6b, 7b) the tempering medium have an equally large cross-section.

7. Apparatus according to one or more of the preceding claims, characterised in that the channel for the process gas (6d, 7d) has a larger cross-sectional area than the channel for supplying and discharging (6a, 7a; 6b, 7b) the tempering medium.

8. Apparatus according to according to one or more of the preceding claims, characterised in that a gas distributor pipe (6f, 7f) is provided in the channel for process gas (6d, 7d).

9. Apparatus according to claim 8, characterised in that the discharge of gas from the gas distributor pipe (6f, 7f) into the channel for process gas (6d, 7d) is preferably effected through an aperture (6k, 7k) in the form of a bore.

10. Apparatus according to claim 9, characterised in that the aperture (6k, 7k) is preferably provided in the centre of the axial extent of the tube and is arranged vertically at the bottom.

11. Apparatus according to one or more of the preceding claims, characterised in that the discharge of gas from the channel for process gas (6d, 7d) into the vacuum chamber (1) is effected through apertures (6e, 6e', ...; 7e, 7e', ...) preferably in the form of bores.

12. Apparatus according to claim 11, characterised in that the gas is distributed through the apertures (6e, 6e', ...; 7e, 7e',...) arranged at specified intervals transverse to the longitudinal axis of the channel (6d,7d) and vertically at the bottom.

13. Apparatus according to claim 12, characterised in that the gas flow generated through the apertures (6e, 6e', ...; 7e, 7e',...) into the vacuum chamber (1) is interrupted by sealing/baffle plates (13, 14), respectively filling the gap between the chamber inner wall and the hollow profile (6, 7) and preferably each being rigidly fixed to the respective hollow profile (6, 7).

14. Apparatus according to one or more of the preceding claims, characterised in that tubular inserts can be housed in the channels (6a, 6b, 6d; 7a, 7b, 7d), their cross-sectional area corresponding to the clear cross-sectional area of the channels and reducing the pressure loss of the medium flowing through the respective channel.

15. Apparatus according to one or more of the preceding claims, characterised in that the one-piece hollow profile (6) passes out through an aperture in the wall of the vacuum chamber (1), the cross-sectional area of the aperture corresponds to that of the hollow profile (6), and a seal is provided between the two parts.

16. Apparatus according to one or more of the preceding claims, characterised in that the hollow profile (6) is surrounded in the immediate region of the aperture in the chamber wall by a collar or flange (23, 24), which in turn abuts the chamber outer wall in a flush manner and seals the gap between the hollow profile (6), the chamber wall and the flange (23, 24) via at least one seal (28, 29).

17. Apparatus according to claim 16, characterised in that the terminal (21) for the line carrying the process gas and the terminal (22) for the line carrying the tempering medium are disposed at one end of the hollow profile (6) and outside the vacuum chamber (1).

## Revendications

1. Dispositif pour la déposition de couches minces sur un substrat (10) au moyen du procédé de pulvérisation cathodique dans une chambre à vide (1), à travers laquelle peut être déplacé le substrat à revêtir (10), et comportant un diaphragme (8, 9) agencé entre une cathode (12) à pulvériser et une anode (4, 5), le plan du substrat (11) s'étendant au-dessous de l'anode (4, 5), et des moyens d'amenée de fluide (6, 7) qui sont tenus par la paroi de la chambre à vide (1) étant prévus parallèlement au plan de la cathode et dans la région entre la cathode (12) et l'anode (4, 5), lesdits moyens étant traversés par un fluide tampon et par un gaz de réaction, les moyens d'amenée de fluide (6, 7) présentant des ouvertures (6e, 6e', ... ; 7e, 7e', ...) pour la sortie du gaz de réaction dans la chambre à vide (1), caractérisé en ce que le fluide tampon ainsi que le gaz de réaction sont menés dans des canaux (6a, 6b, 6d; 7a, 7b, 7d) qui sont formés par un composant réalisé en une seule pièce et en tant que profilé creux (6, 7), les ouvertures (6e, 6e', ...; 7e, 7e', ...) s'étendant transversalement par rapport à l'axe longitudinal des canaux pour la sortie du gaz.

2. Dispositif selon la revendication 1, caractérisé en ce que le profilé creux (6, 7) présente une surface en section rectangulaire dont les coins sont arrondis.

3. Dispositif selon la revendication 1, caractérisé par un profilé creux (6, 7) dont la surface en section est réalisée en tant que triangle ou en tant que polygone, un ou plusieurs coins étant arrondis ou réalisés sous la forme d'arcs de cercle.

4. Dispositif selon l'une quelconque des revendications 1, 2 et 3, caractérisé en ce que le profilé creux (6, 7) est pourvu de plusieurs canaux parallèles à l'axe, de préférence pour l'amenée du fluide tampon (6a, 7a), le retour du fluide tampon (6b, 7b) et le gaz de réaction (6d, 7d).

5. Dispositif selon l'une ou plusieurs des revendications précédentes, caractérisé en ce qu'un ou plusieurs canaux (6a, 6b, 6d ; 7a, 7b, 7d) présentent une surface de section rectangulaire.

6. Dispositif selon l'une ou plusieurs des revendications précédentes, caractérisé en ce que les canaux pour l'amenée et pour le retour (6a, 7a; 6b, 7b) du fluide tampon présentent une section transversale de même taille.

7. Dispositif selon l'une ou plusieurs des revendications précédentes, caractérisé en ce que le caral pour le gaz de réaction (6d, 7d) présente une section transversale supérieure à celle du canal pour l'amenée et le retour (6a, 7a; 6b, 7b) du fluide tampon.

8. Dispositif selon l'une ou plusieurs des revendications précédentes, caractérisé en ce que dans le canal pour le gaz de réaction (6d, 7d) est agencé un tube distributeur de gaz (6f, 7f).

9. Dispositif selon la revendication 8, caractérisé en ce que la sortie de gaz hors du tube distributeur de gaz (6f, 7f) dans le canal pour le gaz de réaction (6d, 7d) s'effectue de préférence via une ouverture (6k,7k) réalisée en tant que perçage.

10. Dispositif selon la revendication 9, caractérisé en ce que l'ouverture (6k, 7k) est prévue de préférence au centre de la longueur d'extension axiale du tube et agencée verticalement vers le bas.

11. Dispositif selon l'une ou plusieurs des revendications précédentes, caractérisé en ce que la sortie du gaz hors du canal pour le gaz de réaction (6d, 7d) dans la chambre à vide (1) s'effectue via des ouvertures (6e, 6e', ... ; 7e, 7e', ...) réalisées de préférence en tant que perçages.

12. Dispositif selon la revendication 11, caractérisé en ce que la distribution du gaz s'effectue via les ouvertures (6e, 6e', ... ; 7e, 7e', ...) agencées à des distances données transversalement par rapport à l'axe longitudinal du canal (6d, 7d) et verticalement vers le bas.

13. Dispositif selon la revendication 12, caractérisé en ce que l'écoulement de gaz produit à travers les ouvertures (6e, 6e', ... ; 7e, 7e', ...) dans la chambre à vide (1) est interrompu par des plaques d'étanchéité/de guidage (13, 14) qui remplissent respectivement l'espace intermédiaire entre la paroi intérieure de la chambre et le profilé creux (6, 7) et qui sont agencées chacune de préférence solidairement sur le profilé creux (6, 7).

14. Dispositif selon l'une ou plusieurs des revendications précédentes, caractérisé en ce que l'on peut mettre en place dans les canaux (6a, 6b, 6d ; 7a, 7b, 7d) des inserts tubulaires dont la surface en section est adaptée à la section transversale libre des canaux et qui réduisent la chute de pression du fluide passant dans le canal respectif.

15. Dispositif selon l'une ou plusieurs des revendications précédentes, caractérisé en ce que le profilé creux (6) réalisé en une seule pièce est mené vers l'extérieur à travers une ouverture dans la paroi de la chambre à vide (1), la surface en section de l'ouverture étant adaptée à celle du profilé creux (6) et un joint étant prévu entre les deux parties.

16. Dispositif selon l'une ou plusieurs des revendications précédentes, caractérisé en ce que le profilé creux (6) est entouré dans la région directe de l'ouverture dans la paroi de la chambre par un col ou une bride (23, 24) qui, à son tour, est appliqué de façon étanche sur la paroi extérieure de la chambre et qui referme la fente entre le profilé creux (6), la paroi de la chambre et la bride (23, 24) via au moins un joint (28, 29).

17. Dispositif selon la revendication 16, caractérisé en ce que le raccord (21) pour la conduite qui mène le gaz de réaction ainsi que le raccord (22) pour la conduite qui mène le fluide tampon sont agencés sur une face frontale du profilé creux (6) et à l'extérieur de la chambre à vide (1).
